# FASCICULE DE BREVET EUROPEEN

(11) **EP 1 525 335 B1**
(45) Date de publication et mention de la délivrance du brevet: **12.10.2016**
(21) Numéro de dépôt: 03750835.5
(22) Date de dépôt: 23.07.2003
(51) Int. Cl.: C23C 14/56, C23C 16/54, H01L 21/00

(54) **INSTALLATION POUR LE TRAITEMENT SOUS VIDE DE SUBSTRATS**
ANLAGE ZUM BEARBEITEN VON SUBSTRATEN UNTER VAKUUM
INSTALLATION FOR THE VACUUM TREATMENT OF SUBSTRATES

(30) Priorité: 01.08.2002 FR 0209955
(43) Date de publication de la demande: 27.04.2005
(73) Titulaire: H.E.F., 42160 Andrezieux-Boutheon (FR)
(72) Inventeur: FOUREZON, Gilles, 42130 Marcilly Le Chatel (FR); POIRSON, Jean-Marc, F-42130 Saint Etienne le Molard (FR)
(74) Mandataire: Cabinet Laurent & Charras
(86) Numéro de dépôt international: PCT/FR2003/002320
(87) Numéro de publication internationale: WO 2004/013375

(56) Documents cités:
- EP-A- 0 657 563
- US-A1- 2001 050 224
- US-B1- 6 315 879
- PATENT ABSTRACTS OF JAPAN vol. 012, no. 237 (C-509), 6 juillet 1988 (1988-07-06) & JP 63 028863 A (ULVAC CORP), 6 février 1988 (1988-02-06)
- PATENT ABSTRACTS OF JAPAN vol. 2002, no. 11, 6 novembre 2002 (2002-11-06) & JP 2002 203883 A (SHIBAURA MECHATRONICS CORP), 19 juillet 2002 (2002-07-19)

## Description

L'invention se rattache au secteur technique notamment des machines de traitement sous vide, par exemple dans le domaine des dépôts sous vide.

Plus particulièrement, le problème que se propose de résoudre l'invention est d'assurer le traitement de grandes séries de pièces à un coût réduit.

Pour atteindre cet objectif, l'homme de l'art a conçu des machines dites « en ligne », dans lesquelles les différentes phases successives du procédé de dépôt sont réalisées dans des chambres dédiées, disposées l'une à la suite de l'autre et reliées par des vannes permettant de les isoler, de sorte que les pièces à traiter passent successivement d'une enceinte à l'autre. Généralement, il y a autant d'enceintes en série qu'il y a d'étapes différentes dans le procédé.

Ce type de machine est bien adapté lorsque toutes les phases du procédé ont des durées du même ordre de grandeur, mais si la durée d'une des phases est notablement plus longue que celle des autres -ce qui est généralement le cas-, c'est elle qui gouverne la cinétique de l'ensemble et donc la productivité de la machine. Aussi ces machines n'ont-elles connu qu'une diffusion très limitée.

Par exemple, dans le domaine technique de la micro-électronique, on peut citer l'enseignement du brevet US 6,315,879. Ce brevet divulgue une installation composée de plusieurs modules qui doivent être séparé par une vanne étanche.

L'invention s'est fixée pour but de remédier à ces inconvénients de manière simple, sure, efficace et rationnelle.

Le problème que se propose de résoudre l'invention est d'assurer le traitement continu de substrats divers notamment dans le cas du dépôt sous vide d'un métal, avec pour objectif, d'une part, de pouvoir réguler la vitesse de traitement non pas sur le temps le plus long mais sur le temps le plus cours, ce qui, bien évidemment, et d'une manière importante, permet de réduire la durée de l'ensemble du traitement, et d'autre part, d'avoir une grande souplesse pendant le fonctionnement en créant un ensemble de traitement modulable et non plus rigide, comme il ressort des solutions techniques utilisées.

Pour résoudre un tel problème et atteindre ces objectifs, il a été conçu et mis au point une installation qui est composée de plusieurs modules indépendants fonctionnellement identiques, alignés et communicants entre eux. Chaque module est lui-même composé d'une chambre de traitement et d'une chambre de transfert.

Avantageusement, mais de façon non limitative, la chambre de traitement est située au-dessus de la chambre de transfert avec laquelle elle communique par une porte étanche au vide et apte à être escamotée par tout moyen approprié pour permettre le transfert des pièces à traiter d'une chambre à l'autre.

Selon une autre caractéristique de l'invention, les différents modules sont alignés de telle façon qu'ils communiquent entre eux par les chambres de transfert, deux chambres de transfert consécutives pouvant ou non être séparées par une porte.

Compte tenu des caractéristiques à la base de l'invention, les pièces à traiter peuvent passer successivement de n'importe quelle chambre de traitement à n'importe quelle autre, sans traverser la chambre de traitement contiguë, ce qui permet de lever le principal handicap des machines en ligne traditionnelles.

Selon un réalisation préférentielle mais non limitative de l'invention, pour résoudre le problème posé de facilement transférer le substrat d'un module à l'autre et de soumettre le substrat à la chambre de traitement sous vide considérée, les moyens de transfert comprennent deux bandes ou chaînes sans fin entraînées positivement et équipées de doigts aptes à coopérer avec des formes complémentaires que présente un support de substrat, entre lesdites bandes étant montée une plate-forme assujettie à des éléments aptes à assurer son déplacement vertical en direction de la chambre de traitement sous vide pour assurer, d'une manière concomitante, le transfert du substrat dans ladite chambre.

Pour résoudre le problème posé de permettre le transfert aisé du substrat d'un module à l'autre, la plate-forme, lors du déplacement linéaire du support de substrat et du substrat, d'un module à l'autre, est positionnée sous le plan défini par les doigts d'entraînement des bandes ou chaînes sans fin.

En position haute de la plate-forme correspondant à l'introduction du substrat dans la chambre de traitement sous vide, la plate-forme fait office de porte étanche à la chambre de traitement sous vide. Dans cette position, les substrats disposés sur leur support, peuvent toujours être entraînés par les doigts des bandes ou chaînes sans fin en étant déplacés sous la plate-forme disposée, comme indiquée, en position de fermeture étanche de la chambre de traitement sous vide considérée.

Pour résoudre le problème posé d'assurer l'introduction du substrat de la chambre de traitement sous vide considérée, les éléments aptes à assurer le déplacement vertical de la plate-forme sont constitués par un ensemble de bielles et de leviers coudés assujettis à au moins un organe de commande du type vérin.

Compte tenu de la conception spécifique de chaque module, le niveau présentant les moyens de transfert, constitue une structure support intégrant dans sa partie basse lesdits moyens tandis que sa partie haute présente un plan d'appui pour la fixation étanche de la chambre de traitement sous vide, ledit plan présentant une ouverture pour l'engagement de substrat.

Pour résoudre le problème posé de mettre sous vide l'ensemble de l'installation composée du nombre de modules désiré, la partie des modules recevant les moyens de transfert constitue une enceinte étanche apte à être mise sous vide, après accouplement de plusieurs modules, les différentes enceintes sont mises simultanément sous vide.

L'invention est exposée ci-après plus en détails à l'aide des figures des dessins annexées dans lesquelles :
- La figure 1 est une vue purement schématique montrant le principe de fonctionnement de l'installation de traitement selon l'invention.

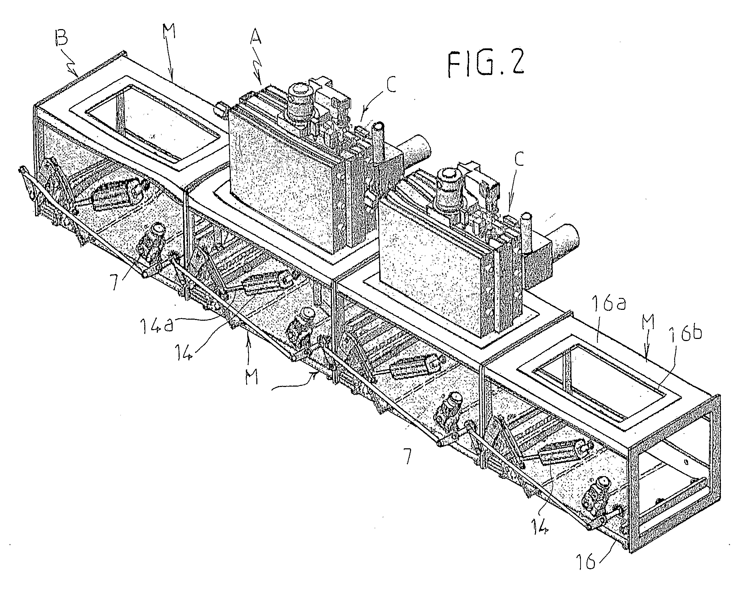

- La figure 2 est une vue en perspective d'un exemple de réalisation de l'installation résultant de l'accouplement en juxtaposition de plusieurs modules.
- Les figures 3, 4, 5 et 6 sont des vues en perspective d'une forme de réalisation d'un module montrant le principe de déplacement et de transfert du substrat.

Selon une caractéristique à la base de l'invention, l'installation est composée d'une pluralité de modules indépendants et alignés qui sont désignés dans leur ensemble par (M). Chaque module (M) est identique fonctionnellement dans son principe, et est composé de deux niveaux (A) et (B) superposés et alignés,

Par exemple, le niveau supérieur (A) présente une chambre de traitement sous vide (C) tandis que le niveau inférieur (B) fait office de chambre de transfert et présente des moyens de transfert du substrat (S) dans une des différentes chambres (C) ou bien d'une chambre à une autre chambre située en aval ou en amont directement à côté ou séparée d'au moins un module.

La conception de chaque module (M), notamment de leurs moyens de transfert, est déterminée de sorte que pendant qu'un substrat est dans une chambre pour un traitement spécifique, un autre substrat peut être transféré dans une autre chambre pour subir un autre traitement.

Comme cela est indiqué dans la suite de la description, les différents modules (M) sont déterminés pour être juxtaposés et alignés, pour être en communication. Les moyens de transfert de deux modules adjacents sont également déterminés pour assurer, en combinaison, le transfert des substrats (S) d'un module à l'autre. Après juxtaposition, les différents modules (M), notamment à leur niveau inférieur (B), peuvent être accouplés entre eux par tous moyens connus et appropriés notamment par simple vissage.

Pour chaque module, les moyens de transfert comprennent deux bandes ou chaînes sans fin parallèles (1) et (2) entraînées positivement. Par exemple, les bandes (1) et (2) coopèrent avec des roues d'entraînement (3) et (4) liées deux à deux par un arbre d'accouplement commun (5) et (6). L'arbre d'accouplement (5) est monté librement dans des paliers tandis que l'arbre d'accouplement (6) est accouplé à un organe moteur (7). Bien évidemment, l'exemple décrit et illustré pour l'entraînement des bandes sans fin (1) et (2) est donné à titre indicatif et non limitatif.

Chaque bande (1) et (2) est équipée de doigts (8) disposés en regard en étant dirigés à l'intérieur de l'espace délimité par lesdites bandes (1) et (2). Ces doigts (8) sont destinés à coopérer avec des formes complémentaires (9a) que présente un support de substrat (9). Par exemple, ce support de substrat (9) est constitué par une simple plaque horizontale. Les formes complémentaires (9a) sont constituées par des encoches. Dans les dessins annexés le substrat, ou le lot de substrats à traiter, est symbolisé par un volume parallélépipédique.

On conçoit que ces dispositions permettent d'assurer le déplacement linéaire du substrat (S) disposé sur le support (9) dont les encoches (9a) coopèrent avec les doigts (8). Après accouplement et juxtaposition de plusieurs modules, le substrat (S) peut être facilement déplacé d'un module à un autre, dans un sens de déplacement déterminé, avec la possibilité de revenir en arrière par inversion du sens de rotation du moteur (7) par exemple.

Entre les bandes (1) et (2) est montée une plate-forme (10) assujettie à des éléments aptes assurer son déplacement vertical, notamment son élévation, en direction de la chambre de traitement sous vide (C) pour assurer, de manière concomitante, le transfert du substrat sur le support (9) dans ladite chambre (C). Par exemple, la plate-forme (10) est supportée par un cadre (11), qui délimite de part et d'autre de ladite plate-forme (10), deux espaces (11a) et (11b) formés en parallèle pour permettre l'intégration et le passage des bandes sans fin (1) et (2). Par exemple, le cadre (11) est assujetti à un ensemble de bielles (12) et de leviers (13), lesdits leviers sont articulés à chacune des extrémités des côtés longitudinaux du cadre (11) et sur une partie fixe du châssis de chaque module, tandis que les bielles (12) sont articulées sur les leviers (13), en combinaison avec des galets (18) par exemple coopérant avec le cadre (11).

L'ensemble bielles (12) et leviers coudés (13), est assujetti par exemple, à un vérin (14) notamment, articulé sur une partie fixe du châssis de chaque module pour permettre sous l'effet du déplacement de sa tige (14a) le déplacement guidé en hauteur, de bas en haut et de haut en bas, de l'ensemble du cadre (11) et de la plate-forme (10).

En position basse, la plate-forme (10) est positionnée sous le plan supérieur défini par les doigts des bandes ou chaînes sans fin d'entraînement (1) et (2). Dans cette position basse, l'ensemble du support avec le substrat (S) peut être transféré régulièrement sans être gêné par la plate-forme (10). La position haute de la plate-forme (10) fait office de porte étanche à la chambre de traitement sous vide considérée.

Les différents moyens de déplacement et de transfert pour le support (9) du substrat (S), sont montés au niveau inférieur par exemple. Chaque module (M) est constitué par une structure (16) en combinaison avec des organes de roulement (15). Par exemple, la structure (16) constitue un caisson de forme généralement parallélépipédique. La partie supérieure de la structure peut présenter, si besoin est, un plan d'appui (16b) pour la fixation, d'une manière étanche, de la chambre de traitement sous vide en tant que telle (C). Le plan d'appui présente une ouverture (16a) pour l'engagement de l'ensemble support (9) substrat (S). Cette ouverture de communication (16a) entre le niveau inférieur (B) et le niveau supérieur (A), lors du traitement des substrats (S), est obturée d'une manière étanche par la plate-forme (10) faisant office de support à l'ensemble plaque (9) substrat (S).

La structure (16) relative au niveau inférieur (B) de chaque module et qui reçoit les moyens de déplacement et de transfert, constitue un caisson ou une enceinte étanche qui peut être mise sous vide. Après accouplement de plusieurs modules, les différentes enceintes (16) sont mises simultanément sous vide par tous moyens connus et appropriés pour un homme du métier.

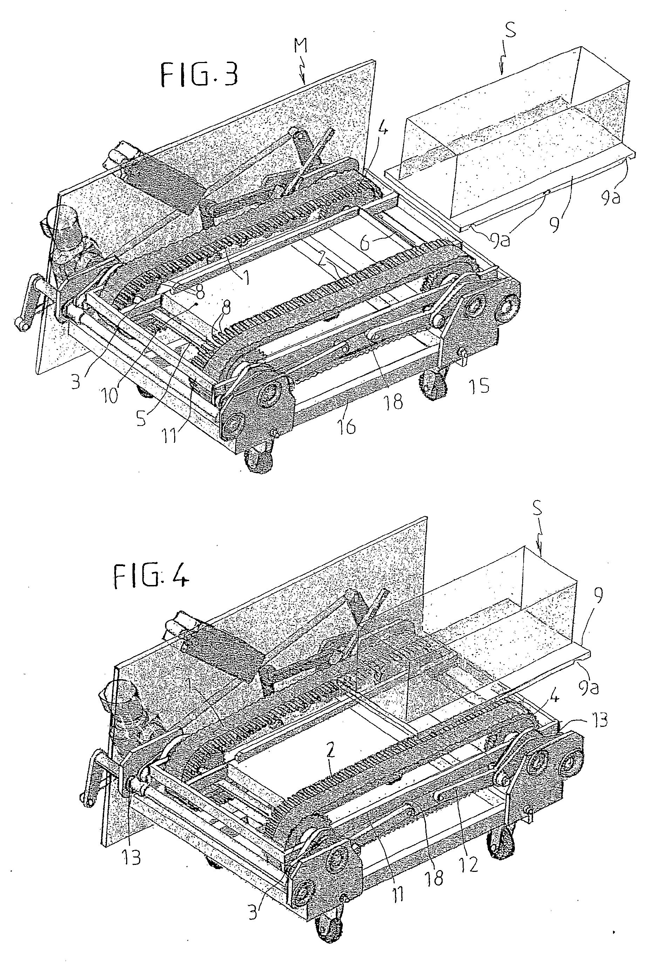

On renvoie aux figures 3, 4, 5 et 6 qui montrent, pour un module, le principe de déplacement linéaire d'un module à l'autre du substrat et son transfert au niveau de la chambre de traitement sous vide considérée.

La figure 3 montre un module en position basse de la plate-forme (10) disposée entre les deux bandes ou chaînes sans fin (1) et (2) en étant située sous le plan supérieur défini par les doigts d'entraînement desdites bandes (1) et (2). Le substrat (S), disposé sur un support (9), est illustré à l'entrée du module de traitement considéré.

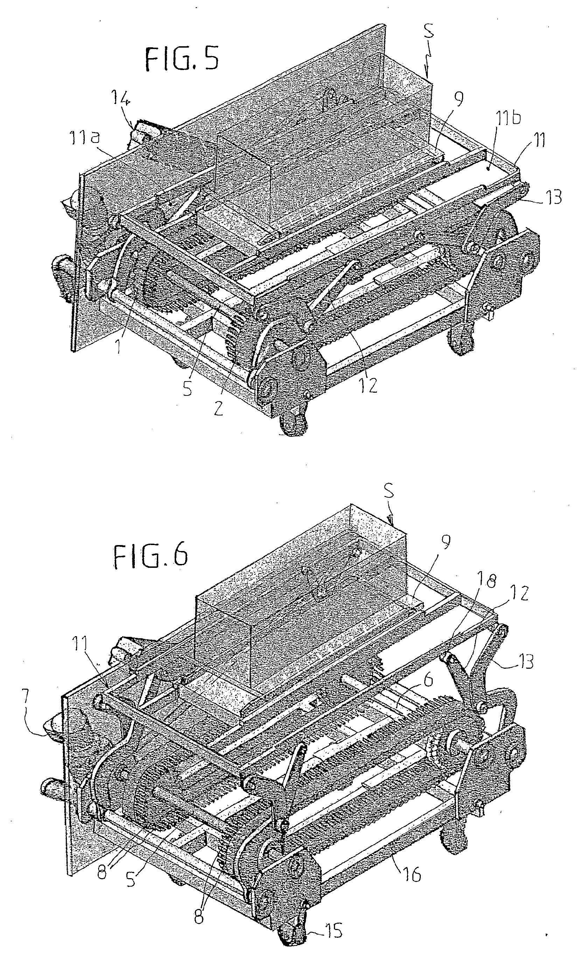

A la figure 4, l'ensemble plaque (9) et substrat (S), coopère par les encoches (9a) avec les doigts d'entraînement (8), l'ensemble du substrat étant déplacé linéairement par les bandes sans fin (1) et (2), la plate-forme (10) étant toujours située en partie basse pour ne pas gêner le déplacement linéaire de l'ensemble du substrat. Lorsque l'ensemble du substrat est positionné en regard et en alignement avec l'ouverture (16b) de la chambre de traitement sous vide considérée, le vérin de commande (14) agit sur l'ensemble des bielles (12) et leviers coudés (13) pour provoquer, de manière concomitante, un déplacement en hauteur de la plate-forme (10) et de manière concomitante de la plaque support (9) et du substrat (S) (figures 5 et 6).

En position haute (figure 6) la plate-forme (10) assure la fermeture étanche de l'ouverture (16a) de la chambre de traitement sous vide.

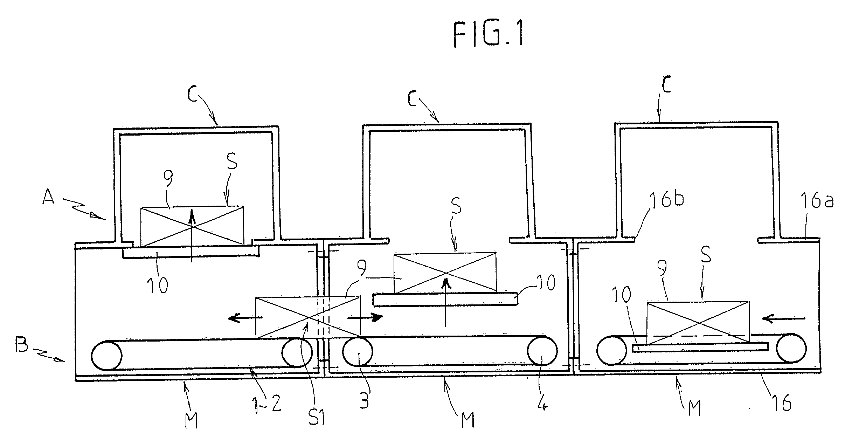

De manière importante, dans cette position haute de la plate-forme, d'autres substrats peuvent être déplacés linéairement d'un module à l'autre quand un autre module est en cours de traitement (substrat (S1), figure 1).

Bien évidemment, les différents moyens de commande pour le déplacement et le transfert du substrat dans les conditions indiquées précédemment sont assujettis à tout type de centrale de commande programmable en fonction du cycle de traitement considéré. Les différents modules sont tous identiques, à l'exception, pour les enceintes de traitement, de certains accessoires spécifiques pour le traitement considéré.

Compte tenu de ces dispositions, et en opposition aux solutions techniques antérieures, un temps de traitement relativement long d'un module ne va pas diminuer, pour autant, l'ensemble du cycle de traitement. Par exemple, si l'on considère un substrat nécessitant plusieurs traitements de 10 minutes et un traitement de 30 minutes, selon l'invention, pour gérer le temps de traitement qui correspond à 30 minutes, l'installation sera équipée, pour ce temps de traitement de 30 minutes, de trois modules strictement identiques de façon à retomber sur un temps de traitement de 10 minutes par chargement. Il en résulte donc que la vitesse de traitement de l'ensemble est régulée sur le temps de traitement le plus court et non plus sur le temps de traitement le plus long.

Les avantages ressortent bien de la description.

## Revendications

1. Installation pour le traitement sous vide de substrats (S) composée de plusieurs modules **caractérisé en ce que** :
- les différents modules (M) sont identiques et indépendants,
- les différents modules sont juxtaposés et alignés pour être en communication,
- chaque module est composé de deux niveaux superposés et alignés,
- l'un des niveaux (A) de chaque module présente une chambre de traitement sous vide (C),
- l'autre niveau (B) de chaque module fait office de chambre de transfert et présente des moyens de transfert d'un substrat dans une des différentes chambres ou bien d'une chambre à une autre chambre située soit en aval soit en amont et soit directement à côté ou séparée d'au moins un module,
- les moyens de transfert sont déterminés pour permettre pendant qu'un substrat est dans une chambre de traitement, de transférer un autre substrat dans une autre chambre pour subir un autre traitement.

2. Installation selon la revendication 1, **caractérisée en ce que** les moyens de transfert comprennent deux bandes ou chaînes sans fin (1) et (2) entraînées positivement et équipées de doigts (8) aptes à coopérer avec des formes complémentaires (9a) que présente un support de substrat (9), entre lesdites bandes (1) et (2) étant montée une plate-forme (10) assujettie à des éléments aptes à assurer son déplacement vertical et son élévation en direction de la chambre de traitement sous vide pour assurer, d'une manière concomitante, le transfert du substrat dans ladite chambre.

3. Installation selon la revendication 2, **caractérisée en ce que** la plate-forme (10), lors du déplacement linéaire du support de substrat (9) et du substrat (S) d'un module à l'autre, est positionnée sous le plan défini par les doigts des bandes ou chaînes sans fin d'entraînement (1) et (2).

4. Installation selon la revendication 2, **caractérisée en ce que** la plate-forme (10) fait office de porte étanche à la chambre de traitement sous vide.

5. Installation selon la revendication 2, **caractérisée en ce que** les éléments aptes à assurer le déplacement vertical de la plate-forme sont constitués par un ensemble de bielles (12) et leviers coudés (13) assujettis à au moins un organe de commande du type vérin (14).

6. Installation selon la revendication 1, **caractérisée en ce que** le niveau (B) présentant les moyens de transfert, constitue une structure support intégrant dans sa partie basse lesdits moyens tandis que sa partie haute présente un plan d'appui pour la fixation étanche de la chambre de traitement sous vide, ledit plan présentant une ouverture pour l'engagement de substrat.

7. Installation selon la revendication 1, **caractérisée en ce que** la partie (B) des modules recevant les moyens de transfert constitue une enceinte étanche apte à être mise sous vide, après accouplement de plusieurs modules (M), les différentes enceintes sont mises simultanément sous vide.

## Patentansprüche

1. Anlage zur Vakuumbehandlung insbesondere von Substraten (S) mit mehreren Modulen, **dadurch gekennzeichnet, dass**:
- die einzelnen Module (M) identisch und unabhängig voneinander sind,
- die einzelnen Module nebeneinander angeordnet und so ausgerichtet sind, dass sie untereinander in Verbindung stehen,
- jedes Modul aus zwei übereinanderliegenden und zueinander ausgerichteten Ebenen besteht,
- eine der Ebenen (A) jedes einzelnen Moduls eine Vakuumbehandlungskammer (C) aufweist,
- die andere Ebene (B) jedes einzelnen Moduls als Transferkammer dient und Mittel aufweist zum Transfer eines Substrats in eine der Kammern oder von einer Kammer in eine andere, entweder vor- oder nachgelagerte oder unmittelbar danebenliegende oder durch mindestens ein anderes Modul getrennte Kammer,
- wobei die Transfermittel so festgelegt sind, dass es möglich ist, während sich ein Substrat in einer Behandlungskammer befindet, ein anders Substrat in eine andere Kammer zu transferieren, um es dort einer anderen Behandlung zu unterziehen.

2. Anlage nach Anspruch 1, **dadurch gekennzeichnet, dass** die Transfermittel zwei Endlosbänder oder Endlosketten (1) und (2) aufweiset, die positiv angetrieben werden und mit Fingern (8) versehen sind, welche mit zusätzlichen Formen (9a) eines Substratträgers (9) zusammenwirken können, wobei zwischen den Bändern (1) und (2) eine mit Elementen verbundene Plattform (10) montiert ist, welche eine vertikale Bewegung und ein Anheben der Plattform zur Vakuumbehandlungskammer sicherstellen kann, um gleichzeitig den Transfer des Substrats in diese Kammer sicherzustellen.

3. Anlage nach Anspruch 2, **dadurch gekennzeichnet, dass** die Plattform (10) bei der linearen Bewegung des Substratträgers (9) und des Substrats (S) von einem Modul zum anderen unterhalb der Ebene positioniert ist, die durch die Finger der Endlosantriebsbänder oder -ketten (1) und (2) definiert wird.

4. Anlage nach Anspruch 2, **dadurch gekennzeichnet, dass** die Plattform (10) als dichte Tür zur Vakuumbehandlungskammer dient.

5. Anlage nach Anspruch 2, **dadurch gekennzeichnet, dass** die Elemente, die die vertikale Bewegung der Plattform sicherstellen können, aus einer Gesamtheit von Pleuelstangen (12) und Kniehebeln (13) bestehen, die mit mindestens einer stellgliedartigen (14) Antriebseinheit verbunden sind.

6. Anlage nach Anspruch 1, **dadurch gekennzeichnet, dass** die Ebene (B), die die Transfermittel aufweist, eine Trägerstruktur bildet, die in ihrem unteren Teil die besagten Mittel enthält, während ihr oberer Teil eine Auflageebene zur dichten Befestigung der Vakuumbehandlungskammer aufweist, wobei diese Ebene zur Eingabe des Substrats eine Öffnung aufweist.

7. Anlage nach Anspruch 1, **dadurch gekennzeichnet, dass** der Bereich (B) der Module, der die Transfermittel erhält, nach Ankopplung mehrerer Module (M) einen dichten, evakuierbaren Behälter darstellt, wobei die einzelnen Behälter gleichzeitig evakuiert werden.

## Claims

1. An installation for vacuum treatment, particularly of substrates (S), consisting of a plurality of modules, **characterized in that**:
- the different modules (M) are identical and independent,
- the different modules are juxtaposed and aligned to be in communication,
- each module is composed of two superimposed and aligned levels,
- one of the levels (A) of each module has a vacuum treatment chamber (C),
- the other level (B) of each module acts as transfer chamber and comprises means of transferring a substrate within one of the different chambers or from one chamber to another located downstream or upstream and directly next to it or separated by at least one module,
- the transfer means being designed to enable while a substrate is in a treatment chamber, the transfer of another substrate into another chamber for a further treatment.

2. Installation as claimed in claim 1, **characterized in that** the transfer means comprise two positively driven endless belts or chains (1) and (2) fitted with projections (8) for interacting with complementary shapes (9a) arranged on a substrate support (9), a platform (10) being fitted between said belts (1) and (2) and being controlled by elements for moving it vertically and elevating it toward the vacuum treatment chamber, thereby transferring concurrently the substrate into said chamber.

3. Installation according to claim 2, **characterized in that** the platform (10) is positioned, during the linear movement of the substrate support (9) and the substrate (S) from one module to the next, under the plane defined by the projections of the endless driving belts or chains (1) and (2).

4. Installation as claimed in claim 2, **characterized in that** the platform (10) acts as a sealing door for the vacuum treatment chamber.

5. Installation as claimed in claim 2, **characterized in that** the elements for moving the platform vertically consist of a set of links (12) and bent levers (13) controlled by at least one actuating member of the jack type (14).

6. Installation as claimed in claim 1, **characterized in that** the level (B) having the transfer means forms a support structure incorporating said means in its lower part, while its upper part has a support plane for the sealed fixing of the vacuum treatment chamber, said plane having an opening for the engagement of the substrate.

7. Installation as claimed in claim 1, **characterized in that** the part (B) of each module receiving the transfer means consists of a sealed enclosure in which a vacuum can be created, a vacuum being created simultaneously in the different enclosures after a plurality of modules (M) have been joined together.
